# EUROPEAN PATENT APPLICATION

(11) **EP 4 212 652 A1**
(43) Date of publication of application: **19.07.2023**
(21) Application number: 21866051.2
(22) Date of filing: 09.09.2021
(51) Int. Cl.: C30B 15/00

(54) **CRYSTAL PRODUCTION PROCESS**

(30) Priority: 10.09.2020 CN 202010948861
(71) Applicant: Zhonghuan Advanced Semiconductor Materials Co., Ltd., Wuxi, Jiangsu 214203 (CN)
(72) Inventor: CHEN, Yi, Wuxi, Jiangsu 214203 (CN); LIU, Qi, Wuxi, Jiangsu 214203 (CN); HUANG, Mo, Wuxi, Jiangsu 214203 (CN); LIU, Linyan, Wuxi, Jiangsu 214203 (CN); GAO, Haitang, Wuxi, Jiangsu 214203 (CN)
(74) Representative: Delbarba, Andrea
(86) International application number: PCT/CN2021/117537
(87) International publication number: WO 2022/052999

(57) **Abstract**

A method of growing the ingot, including following steps: S1, providing an initial charge into a crucible; S2, heating the crucible to melt the initial charge, and after a set time, rotating the crucible at a rotation speed within a set speed range; S3, after a melting process of the charge is completed, descending a feed device to the position above the melt level in the crucible and a distance between feed device and the melt level being h, the feed device including a feed tube, and the feed tube adding a charge into a feed zone of the crucible; and S4, feeding in the feed zone, and growing an ingot in a growth zone. In SI, the initial charge is respectively loaded into a first chamber, a second chamber and a third chamber, and a particle diameter of the initial charge in the first chamber is greater than a particle diameter of the initial charge in the second chamber and in the third chamber. The production process can make the melt in the crucible more uniform, which is beneficial for improving the ingot quality.

## Description

### Cross-Reference to Related Application

This invention claims priority to Application No. 202010948861.8, filed to the China National Intellectual Property Administration on September 10, 2020 and entitled "Method of growing ingot".

### Technical Field

The present invention relates to the technical field of ingot processing, and in particular, to a method of growing an ingot.

### Background

In the related art, the production of crystal silicon using CCZ (Continuous Czocharlski method) usually uses a double crucible or a quartz ring to separate a charge melting zone from a growth zone. However, during the growth of ingots, there are still problems of inhomogeneous melt of the melt zone and the growth zone and poor ingot quality, and it is easy to spatter during charge, causing the ingots not easy to grow.

### Summary

The present invention is intended to resolve at least one of the technical problems in the prior art. For this purpose, the present invention provides a method of growing an ingot. The method of growing the ingot may make the melt in the crucible more uniform, thereby improving the quality of ingots.

The method of growing the ingot according to the present invention includes the following steps: S1, providing an initial charge in a crucible; S2, heating the crucible to melt the initial charge, and after a set time, rotating the crucible at a rotation speed within a set speed range, so as to homogenize a temperature of melt in the crucible; S3, after a melting process of the charge is completed, descending a feed device to a position above a melt level in the crucible and to a distance h from the melt level, the feed device including a feed tube, and the feed tube adding a charge to a feed zone of the crucible; and S4, feeding in the feed zone, and growing an ingot in a growth zone. The crucible includes a first crucible, a second crucible and a third crucible. A containing space is defined in the first crucible, and a top side of the containing space is disposed in an open manner. The second crucible is disposed in the containing space and defines a first chamber together with the first crucible. The third crucible is disposed in the second crucible and defines a second chamber together with the second crucible. A third chamber is defined in the third crucible. A first through hole is formed on the second crucible, so as to communicate the first chamber and the second chamber. A second through hole is formed on the third crucible, so as to communicate the second chamber and the third chamber. The first chamber is adapted to be constructed as the feed zone. The growth zone is located in the third chamber. In S1, the initial charge is separately loaded into the first chamber, the second chamber and the third chamber. A particle diameter of the initial charge in the first chamber is greater than a particle diameter of the initial charge in the second chamber and in the third chamber.

According to the method of growing the ingot of the present invention, in a charge-loading process, by designing the particle diameter of the initial charge in the first chamber R1 to be greater than the particle diameter of the initial charge in the second chamber and the third chamber, it is easy to be ensured that there is enough initial charge contained in the second chamber and the third chamber, and growing the ingot is prevented from being affected caused by generating air bubbles in the second chamber and the third chamber during charge melting, thereby ensuring the quality of ingot. During charge melting, by setting the crucible to maintain rotating at a speed within the set speed range, so as to homogenize a temperature of the melt in the crucible, the melt in the crucible is more uniform, thereby further improving the quality of the ingots.

In some embodiments, a rotation speed ranges from 0.2 r/m to 3 r/m within the set speed range.

In some embodiments, the distance h meets the following: 2 mm ≤ h ≤ 4 mm.

In some embodiments, S4 includes: S41, seed: immersing a part of a seed below the melt level of the crucible, and starting a magnetic field apparatus; S42, neck: pulling the seed at the speed within a set range for neck, so as to eliminate dislocation; S43, crown and shoulder: controlling a heating power and a pulling speed of the seed, so as to increase a diameter of the ingot to a set diameter; and S44, body and feeding: producing equal-diameter growing of the ingot in the growth zone, in the feed zone, adding the charge to the feed zone of the crucible by the feed tube, and controlling a feeding amount of the feed device to be equal to a yield of the ingot, so as to maintain the constant melt level. The crucible is installed in a furnace body of a crystal growing furnace, and the magnetic field apparatus is installed outside the furnace body and generates magnetic fields.

In some embodiments, in S1, before the charge is provided in the crucible, a heater and an insulation layer are successively mounted in the furnace body. The heater is configured to heat the crucible. The insulation layer is located outside the heater. A crucible shaft is raised to a first height position, and the crucible is mounted to the crucible shaft. The crucible shaft is mounted to the furnace body in a liftable manner, and is used to drive the crucible to rotate. After the charge is provided in the crucible, the crucible shaft is descended to a second height position, and a reflector is mounted in the furnace body; and the reflector is configured to separate the growth zone.

In some embodiments, the furnace body includes a body and an upper cover. The heater, the insulation layer, the crucible shaft and the reflector are all mounted on the body. The method of growing the ingot further includes: S5, installing a cooling jacket and the feed device to the upper cover, fixing the upper cover on the body, and then vacuumizing the furnace body, wherein the cooling jacket is configured to cool the ingot, and S5 is between S1 and S2.

In some embodiments, an aperture of the first through hole is d₁, and an aperture of the second through hole is d₂, where d₁ and d₂ meet: d₁ < d₂.

In some embodiments, the first through hole is formed at a bottom of the second crucible and is adjacent to an R angle of the second crucible. There are a plurality of first through holes, and the plurality of first through holes include a first feeding hole and a second feeding hole. The second feeding hole is located above the first feeding hole.

In some embodiments, the first crucible includes a crucible bottom wall and a crucible sidewall. The crucible sidewall extends upwards from an edge of the crucible bottom wall and defines the containing space together with the crucible bottom wall. Both the second crucible and the third crucible are formed as cylindric structures. The second crucible is fitted with the crucible bottom wall in a limited manner by a first mortise and tenon structure. The third crucible is fitted with the crucible bottom wall in a limited manner by a second mortise and tenon structure.

In some embodiments, a top end of the first crucible and a top end of the second crucible are disposed flush with each other and are both located above a top end of the third crucible.

In some embodiments, the crucible further includes a fourth crucible. The fourth crucible is disposed in the third chamber so as to separate the third chamber into a first sub-chamber and a second sub-chamber. A third through hole is formed on the fourth crucible, so as to communicate the first sub-chamber and the second sub-chamber. The second sub-chamber communicates with the second chamber by the second through hole. The first sub-chamber is adapted to be constructed as the growth zone, and the second chamber is adapted to be constructed as a dopant feed zone. In S1, the particle diameter of the initial charge in the first chamber is greater than the particle diameter of the initial charge in the first sub-chamber and the second sub-chamber. The feed device further includes a dopant feed tube. In S3, the feed tube is disposed corresponding to the feed zone, so as to cause the feed tube to add the charge to the first sub-chamber. The dopant feed tube is corresponding to the dopant feed zone, so as to cause the dopant feed tube to add dopants to the second sub-chamber.

In some embodiments, an aperture of the first through hole is d₁, the aperture of the second through hole is d₂, and an aperture of the third through hole is d₃, where d₁, d₂ and d₃ meet: d₁ < d₂ < d₃.

In some embodiments, a top end of the first crucible, a top end of the second crucible and a top end of the third crucible are flush with each other and are all located above a top end of the fourth crucible.

In some embodiments, the crucible further includes a tray. The tray is supported at a bottom of the first crucible. A top end of the tray is located below a top end of the first crucible, a top end of the second crucible and a top end of the third crucible. The first crucible includes a crucible bottom wall and a crucible sidewall. The crucible sidewall extends upwards from the crucible bottom wall and defines the containing space together with the crucible bottom wall. The top end of the tray is adapted to be located above the melt level in the containing space, and a height of a portion of the tray which is beyond the crucible bottom wall is half of a height of the first crucible.

Additional aspects and advantages of the present invention will be partially set forth in the following description, and in part will be apparent from the following description, or may be learned by practice of the present invention.

### Brief Description of the Drawings

Fig. 1 is a schematic flowchart of a method of growing an ingot according to an embodiment of the present invention.
Fig. 2 is a schematic flowchart of a method of growing an ingot according to another embodiment of the present invention.
Fig. 3 is a schematic flowchart of a method of growing an ingot according to another embodiment of the present invention.
Fig. 4 is a schematic flowchart of a method of growing an ingot according to another embodiment of the present invention.
Fig. 5 is a schematic diagram of a crucible according to an embodiment of the present invention.
Fig. 6 is a partial schematic diagram of the crucible shown in Fig. 5.
Fig. 7 is a schematic diagram of the crucible shown in Fig. 5 applied to a monocrystal furnace.
Fig. 8 is a schematic diagram of a crucible according to another embodiment of the present invention.
Fig. 9 is a schematic diagram of the crucible shown in Fig. 8 applied to a monocrystal furnace.

In the drawings:
200, Furnace body; 200a, Body; 200b, Upper cover;
101, Feed device; 1011, Feed tube; 1012, Dopant feed tube; 102, Seed; 102b, Solid-liquid interface;
103, Magnetic field apparatus; 1031, First energized coil; 1032, Second energized coil; 104, Heater; 1041, Side heater;
1050, Avoidance space;
105, Insulation layer; 1051, First insulation layer; 1052, Second insulation layer; 1052a, First insulation sub-layer; 1052b, Second insulation sub-layer;
106, Crucible shaft; 107, Reflector; 108, Cooling jacket;
100, Crucible; 100a, Containing space;
R1, First chamber; R2, Second chamber; R3, Third chamber; R31, First sub-chamber; R32, Second sub-chamber;
Ω1, Feed zone; Ω2, Dopant feed zone; Ω3, Growth zone;
1, First crucible; 11, First body; 12, Crucible bottom wall; 13, Crucible sidewall;
2, Second crucible; 20, First through hole; 20a, First feeding hole; 20b, Second feeding hole; 21, Second body;
3. Third crucible; 30, Second through hole; 31, Third body;
4, Fourth crucible; 40, Third through hole; 41, Fourth body;
5, First mortise and tenon structure; 6, Second mortise and tenon structure; 7, Third mortise and tenon structure;
8, Tray.

### Detailed Description of the Embodiments

Embodiments of the present invention are described in detail below. Examples of the embodiments are shown in the accompanying drawings, where the same or similar reference numerals throughout the invention represent the same or similar elements or the elements having the same or similar functions. The embodiments described below with reference to the accompanying drawings are exemplary and are used to explain the present invention, but should not be construed as a limitation on the present invention.

The following invention provides many different embodiments or examples for implementing different structures of the present invention. In order to simplify the embodiments of the present invention, components and settings of specific examples are described below. Definitely, the above are merely examples and are not intended to limit the present invention. Furthermore, the present invention may repeat reference numerals and/or letters in different examples. The repetition is for simplicity and clarity, which itself does not indicate a relationship between the embodiments and/or configurations discussed. In addition, examples of various specific processes and materials are provided in the present invention, but the ordinary skill in the art may recognize the applicability of other processes and/or the use of other materials.

A method of growing an ingot according to the embodiments of the present invention is described below with reference to the drawings. "An ingot" may refer to crystal silicon, sapphire, or the like.

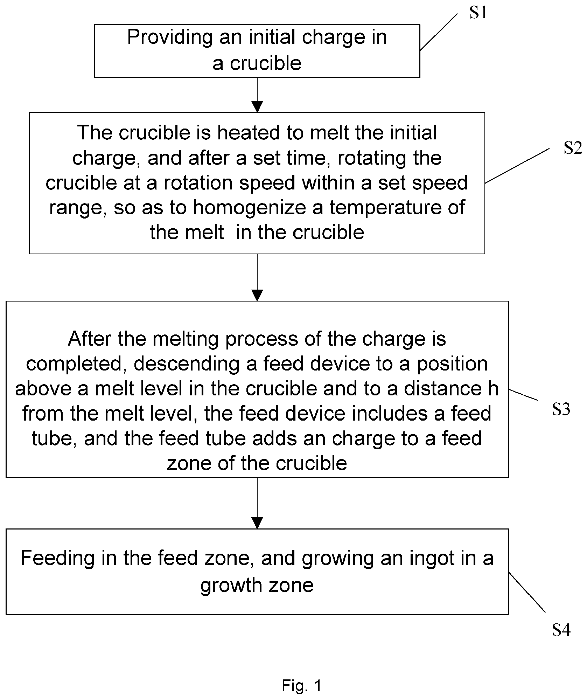

As shown in Fig. 1 to Fig. 4, the method of growing the ingot includes the following steps: S1, providing an initial charge in a crucible 100; S2, heating the crucible 100 to melt the initial charge, and after a set time, rotating the crucible 100 at a rotation speed within a set speed range, so as to equalize an internal temperature of the crucible 100; S3, after a melting process of the charge is completed, descending a feed device 101 to a position above a melt level in the crucible 100 and to a distance h from the melt level in a vertical direction, the feed device 101 includes a feed tube 1011, and the feed tube 1011 adding a charge to a feed zone Ω1 of the crucible 100; and S4, feeding in the feed zone Ω1, and growing an ingot in a growth zone Ω3.

For example, charge providing is first performed; the initial charge is loaded in the crucible 100; and based on the height of the melt level required by the crucible 100, the total mass of the initial charge required to be added in S1 is calculated. Then charge melting is performed; the crucible 100 is heated to melt the initial charge in the crucible 100, so as to melt the initial charge in the crucible 100 to a certain extent within the set time; after the initial charge is melted to a certain extent, the crucible 100 maintains to rotate at the rotation speed within the set speed range, so as to cause a temperature of the melt in the crucible 100 to be more homogenized, thereby it is benefit to improve the quality of ingots; in addition, the rotation of the crucible 100 causes the melt in the crucible 100 to be more homogenized. After the charge is completely melted, the feed device 101 is descended to the distance h above the melt level in the crucible 100; the feed tube 1011 adds the charge to a feed zone Ω1 of the crucible 100, and the feeding amount may make the height of the melt level in the crucible 100 reach a required height of the melt level; in addition, in a feeding process, there is a certain height difference between the feed device 101 and the melt level, such that there is an enough feeding space between the feed device 101 and the melt level, thereby facilitating the feed device 101 to add the charge to the crucible 100, and preventing the feed device 101 from immersing into the melt level during feeding. Finally, the charge is fed in the feed zone Ω1, and the ingot is growing in a growth zone Ω3 of the crucible 100, such that the charge is fed while the ingot is grown, thereby achieving the production of the ingots by CCZ (Continuous Czocharlski method).

It is to be noted that, in step S3, the feed device 101 is descended to the distance h above the melt level in the crucible 100, and then feeding is performed. Then "the melt level in the crucible 100" which is h away from the feed device 101 in a vertical direction may be understood as the position of the melt level in the crucible 100 before feeding.

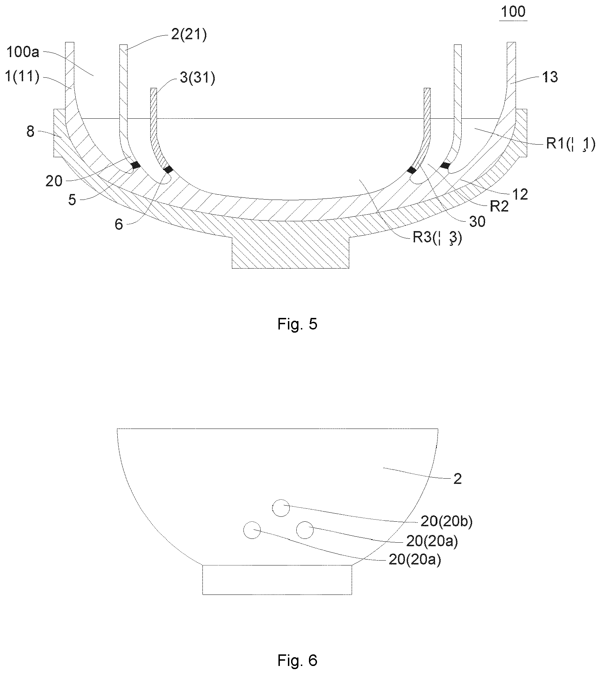

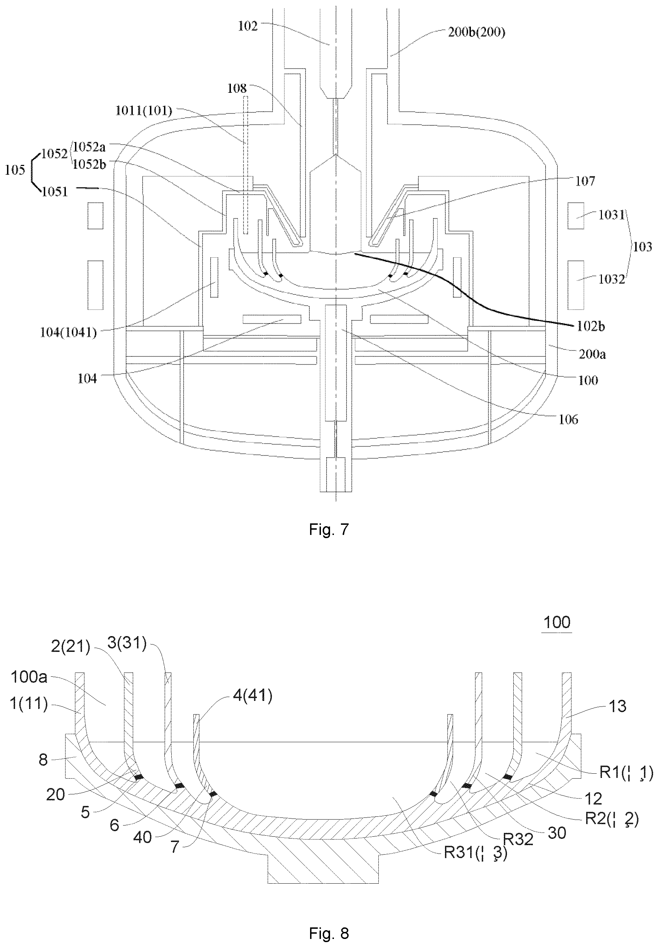

As shown in Fig. 5 and Fig. 8, the crucible 100 is the crucible 100 used in the method of growing the ingot. The crucible 100 includes a first crucible 1, a second crucible 2 and a third crucible 3. A containing space 100a is defined in the first crucible 1, and a top side of the containing space 100a is disposed in an open manner. The containing space 100a may be used to contain a melt (or molten soup) of a semiconductor or a solar grade material (such as silicon), and the melt may be formed by heating a solid charge. The second crucible 2 is disposed in the containing space 100a and defines a first chamber R1 together with the first crucible 1. The first chamber R1 belongs to a part of the containing space 100a, and may be located outside the second crucible 2. The third crucible 3 is disposed in the second crucible 2 and defines a second chamber R2 together with the second crucible 2. A third chamber R3 is defined in the third crucible 3. Both the second chamber R2 and the third chamber R3 belong to a part of the containing space 100a, and the second chamber R2 may be located outside the third chamber R3.

A first through hole 20 is formed on the second crucible 2, so as to communicate the first chamber R1 and the second chamber R2, such that the melt in the first chamber R1 may flow to the second chamber R2 by the first through hole 20, or the melt in the second chamber R2 may flow to the first chamber R1 by the first through hole 20. A second through hole 30 is formed on the third crucible 3, so as to communicate the second chamber R2 and the third chamber R3, such that the melt in the second chamber R2 is able to flow to the third chamber R3 by the second through hole 30.

As shown in Fig. 5 and Fig. 8, the first chamber R1 is adapted to be constructed as the feed zone Ω1, and the growth zone Ω3 is located in the third chamber R3. Then in step S3, the feed tube 1011 adds the charge into the first chamber R1 again. In step S4, growing the ingot in the third chamber R3. Since the melt in the first chamber R1 can only flow to the third chamber R3 by the second chamber R2, the second chamber R2 is adapted to be constructed as a "melting zone", such that the melt has enough heating time, and an enough mixing space is provided for the melt formed after melting. Therefore, the homogenization of the melt in the third chamber R3 is improved, and a problem that the growth of the ingot is affected due to the fact that the incompletely melted charge directly enters the growth area Ω3 is prevented, so as to grow the ingots with high quality. In addition, by disposing the second chamber R2 to separate the third chamber R3 from the first chamber R1, disturbance of the melt level may be avoided when the charge is added into the first chamber R1, such that the stability of the melt level during feeding is guaranteed, so as to achieve stable growth of the ingots, thereby guaranteeing stable production.

Wherein, in step S1, the loading of the initial charge in the crucible 100 is to separately load the initial charge in the first chamber R1, the second chamber R2 and the third chamber R3. The particle diameter of the initial charge in the first chamber R1 is greater than the particle diameter of the initial charge in the second chamber R2 and in the third chamber R3, such that the particle diameter of the initial charge in the first chamber R1 is relatively large, so as to ensure the loading rate of the first chamber R1; and the particle diameter of the initial charge in the second chamber R2 and the particle diameter of the initial charge in the third chamber R3 are relatively small, so as to contain enough initial charge in the second chamber R2 and in the third chamber R3. In addition, gaps between initial charge particles in the second chamber R2 and in the third chamber R3 are relatively small, such that air bubbles are prevented from being generated during charge melting, and in particular, avoid a problem of affecting ingot growing due to generation of air bubbles in the third chamber R3.

It is to be noted that, in the method of growing the ingot, the steps may be sequential. For example, step S1, step S2, step S3 and step S4 are performed in order, so as to cause the "loading an initial charge in a crucible 100" in step S1 to be prior to the "heating the crucible 100 to melt the initial charge" in step S2, and the charge melting process in step S2 is to melt the initial charge added in the crucible 100 in step S1. The "rotating the crucible 100 at a rotation speed within a set speed range, so as to homogenize a temperature of the melt in the crucible 100" in step S2 is prior to the "descending a feed device 101 to a position above a melt level in the crucible 100 and to a distance h from the melt level" in step S3, and the discharging process in step S3 is prior to the feeding and ingot growing processes in step S4.

Therefore, according to the method of growing the ingot of the embodiments of the present invention, by means of, in a feeding process, designing the particle diameter of the initial charge in the first chamber R1 to be greater than the particle diameter of the initial charge in the second chamber R2 and the third chamber R3, it is ensured that there is enough initial charge contained in the second chamber R2 and the third chamber R3, and ingot growing is prevented from being affected caused by air bubbles generated in the second chamber R2 and the third chamber R3 during charge melting, thereby guaranteeing the quality of ingots. During charge melting, by setting the crucible 100 to maintain rotating at a rotation speed within the set speed range, so as to homogenize a temperature of the melt in the crucible 100, the melt in the crucible 100 is more homogenized, thereby it is beneficial to improve the quality of the ingots.

In some embodiments, in step S1, the particle diameter of the initial charge in the first chamber R1 is greater than 10 mm. For example, the particle diameter of the initial charge in the first chamber R1 may be greater than 50 mm, 60 mm, 70 mm, 100 mm or 200 mm. Therefore, the first chamber R1 has a low requirement for the particle diameter of the initial charge, thereby guaranteeing the feeding rate of the first chamber R1. The particle diameters of the initial charges in the second chamber R2 and the third chamber R3 are less than 10 mm, so as to avoid a problem of affecting ingot growing due to generation of air bubbles in the second chamber R2 and the third chamber R3.

In some embodiments, a rotation speed ranges from 0.2 r/m to 3 r/m (including endpoint values, where "r/m" is rotation per minute, or may be written as rpm) within the set rotation speed range. In this case, the rotation speed of the crucible 100 is relatively low, such that slight rotation of the crucible 100 is realized, thereby ensuring the homogenized effect of the temperature in the crucible 100. For example, after the set time, the rotation speed of the crucible 100 may be 0.2 r/m, 1.5 r/m, 2.3 r/m or 3 r/m. It is understandable that, the rotation speed of the crucible 100 may be maintained at a certain constant rotation speed value all the time, or may be adjusted within the range of 0.2 r/m-3 r/m according to a set mode. By the slight crucible rotation at a melting phase, the temperature of the melt in the crucible 100 may be more homogenized, thereby it is beneficial to improve the quality of the ingot. If the speed is too fast, melt level fluctuation may be caused; and if the speed is too small, the purpose of more homogenized temperature cannot be achieved.

In some embodiments, the distance h meets 2 mm ≤ h ≤ 4 mm, such that h may be 2 mm, 3 mm or 4 mm. For example, h is 3 mm, and in step S3, the feed device 101 is descended to 3 mm above the melt level in the crucible 100. In this way, there is a suitable height difference between the feed device 101 and the melt level in the crucible 100, such that difficult growth of the ingots due to easy spattering of feeding caused by too high position of the feed device 101 is avoided, and the problem of easily polluting the melt in the crucible 100 due to the fact that the position of the feed device 101 is too low is avoided, thereby further ensuring the stable growth of the ingots and the quality of the ingots.

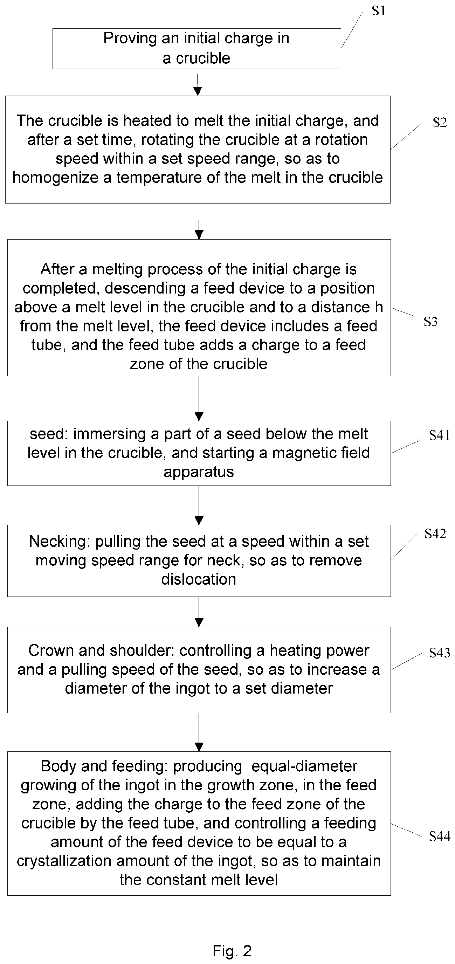

In some embodiments, as shown in Fig. 2, step S4 includes: step S41, seed: immersing a part of a seed 102 below the melt level of the crucible 100, and starting a magnetic field apparatus 103; step S42, neck: pulling the seed 102 at the speed within a set moving speed range for neck, so as to eliminate dislocation; S43, crown and shoulder: controlling a heating power and the pulling speed of the seed 102, so as to increase the diameter of an ingot to a set diameter; and S44, body and feeding: performing equal-diameter growing of an ingot in the growth zone Ω2, in the feed zone Ω1, adding the charge to the feed zone Ω1 of the crucible 100 by the feed tube 1011, and controlling the feeding amount of the feed device 101 to be equal to the yield of the ingot, so as to maintain the constant melt level. In step S44, equal-diameter growing of the ingots is performed while the charge is added to the feed zone Ω1, such that simultaneous performing of body and feeding are realized.

For example, in some embodiments, step S4 includes: about one third of the seed 102 in an axial direction is immersed into the melt of the crucible 100, and the magnetic field apparatus 103 is started (i.e. open). When the temperature is stabilized, neck is started. During neck, the seed 102 is lifted upwards with a speed within the set moving speed range, so as to control the diameter of a necking portion of the ingot. Then, the heating power and the pulling speed of the seed 102 are controlled, so as to increase the diameter of the ingot to a set diameter. In this process, on the basis of controlling the shape of the ingot, geometry and an ingot growth angle are calculated by a length-width ratio, and the heating power and the pulling speed are controlled according to an empirical shape, to cause the shape of the ingot to reach a required angle, so as to complete crown and shoulder. When the diameter of the ingot is close to the set diameter and equal the set diameter, crown and shoulder are completed. In this case, the charge is added to the feed zone Ω1 of the crucible 100, such that the melt level is maintained to be constant in an equal-diameter, and the equal-diameter growth of the ingot is achieved, until the ingot is separated from the melt level.

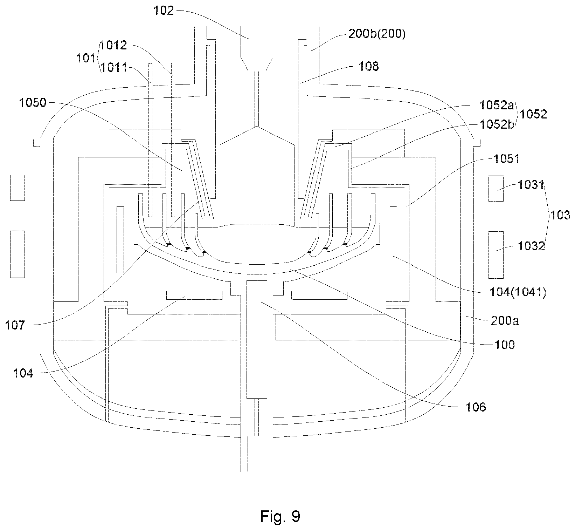

As shown in Fig. 7 and Fig. 9, the crucible 100 is disposed in a furnace body 200 of a crystal growing furnace. The magnetic field apparatus 103 is disposed outside the furnace body 200 and generates magnetic fields. The magnetic field generated by the magnetic field apparatus 103 may be applied to the melt in the crucible 100. It is understandable that, the height of the magnetic field apparatus 103 is specifically set according to actual requirements.

In step S44, when the crown and shoulder of the ingot are completed, the feed device 101 is opened, in this case, the ingot is grown in equal diameter, and the feeding amount of the feed device 101 is maintained to be equal to the added weight of the ingot. For example, for every 1 kg increase in the weight of the ingot, 1 kg of charge needs to be added to the crucible 100 from the feed device 101. That is to say, during the equal-diameter growth of the ingot, the decrease in mass of the melt due to the rise of the seed 102 at a certain height needs to be replenished accordingly by adding the same mass of the charge to the feed device 101. Therefore, the stable melt level is maintained during the growth of the ingot, the stable growth of the ingot is further guaranteed, and continuous feeding and growth of the ingot are realized, thereby it is easy to grow the ingots with large sizes. For example, the growth of crystal silicon may be received by continuous feeding, so as to solve the problem of segregation of heavily doped ingots easily.

For example, in an example of Fig. 7, the feed device 101 includes a feed tube 1011. In step S44, the feed tube 1011 is opened, and the feeding amount of the feed tube 1011 is controlled to be equal to the yield of the ingot, such that after the crown and shoulder of the ingot are completed, the feed tube 1011 may be opened. In this case, the ingot is grown in equal diameter, and the feeding amount of the feed tube 1011 is maintained to be equal to the added weight of the ingot. For example, for every 1 kg increase in the weight of the ingot, 1 kg of the charge needs to be added to the crucible 100 from the feed tube 1011, so as to maintain the melt level stable during ingot growth. It is understandable that, in an example of Fig. 7, during growing ingot, if the dopant needs to be added into the crucible 100, in step S44, the feed tube 1011 and a dopant feed tube 1012 are opened, and the sum of the feeding amount of the feed tube 1011 and the feeding amount of the dopant feed tube 1012 is controlled to be equal to the yield of the ingot.

For another example, in an embodiment of Fig. 9, the feed device 101 includes the feed tube 1011 and the dopant feed tube 1012. In step S44, the feed tube 1011 and the dopant feed tube 1012 are opened, and the sum of the feeding amount of the feed tube 1011 and the feeding amount of the dopant feed tube 1012 is controlled to be equal to the yield of the ingot, such that after the crown and shoulder of the ingot are completed, the feed tube 1011 and the dopant feed tube 1012 may be opened. In this case, the ingot is grown in equal diameter, and for every 1 kg increase in the weight of the ingot, 1 kg of the charge needs to be totally added to the crucible 100 from the feed tube 1011 and the dopant feed tube 1012, so as to maintain the melt level stable during ingot growth.

In some embodiments, as shown in Fig. 7 and Fig. 9, the magnetic field apparatus 103 includes a first energized coil 1031 and a second energized coil 1032. Both the first energized coil 1031 and the second energized coil 1032 are disposed around the furnace body 200. The first energized coil 1031 is adapted to be located above a solid-liquid interface of the melt in the crucible 100. The second energized coil 1032 is spaced under the first energized coil 1031, and is adapted to be located under the solid-liquid interface of the melt in the crucible 100. Therefore, the magnetic field apparatus 103 is simple in structure and convenient for implementing.

Wherein, the second energized coil 1032 and the first energized coil 1031 have an opposite current direction, so as to make the magnetic field apparatus 103 generate a cusp-type magnetic field. Under the action of magnetic lines in the cusp-type magnetic field, magnetic lines of force between the first energized coil 1031 and the second energized coil 1032 are in "cusp-type" symmetrical distribution. For example, when the ingot grows, the solid-melt interface is located on a symmetrical surface between the first energized coil 1031 and the second energized coil 1032, such that most of the melt is inhibited by the magnetic field, thereby effectively reducing the generation of turbulence in the melt.

In some embodiments, as shown in Fig. 7, both the first energized coil 1031 and the second energized coil 1032 are coaxial with the furnace body 200, such that a central axis of the first energized coil 1031, a central axis of the second energized coil 1032 and a central axis of the furnace body 200 coincide with each other. The first energized coil 1031 and the second energized coil 1032 are adapted to be symmetrically disposed with regard to the solid-melt interface 102b of the melt in the crucible 100. In this case, currents in the first energized coil 1031 and the second energized coil 1032 may be the same, and the number of turns of the first energized coil 1031 and the second energized coil 1032 may be the same, so as to simplify the arrangement of the magnetic field apparatus 103.

In some embodiments, in step S42, the range of the set moving speed is 2 mm/min-3 mm/min (including endpoint values), so as to guarantee the successful proceeding of neck. For example, in step S42, the seed 102 is controlled to be lifted upwards with a stable moving speed, to cause the diameter of the necking portion of the ingot to be between 5 mm-6 mm, so as to eliminate dislocation; and after the necking portion of the ingot reaches a certain length, for example, 200 mm, the heating power and the pulling speed of the seed 102 are controlled to perform crown and shoulder.

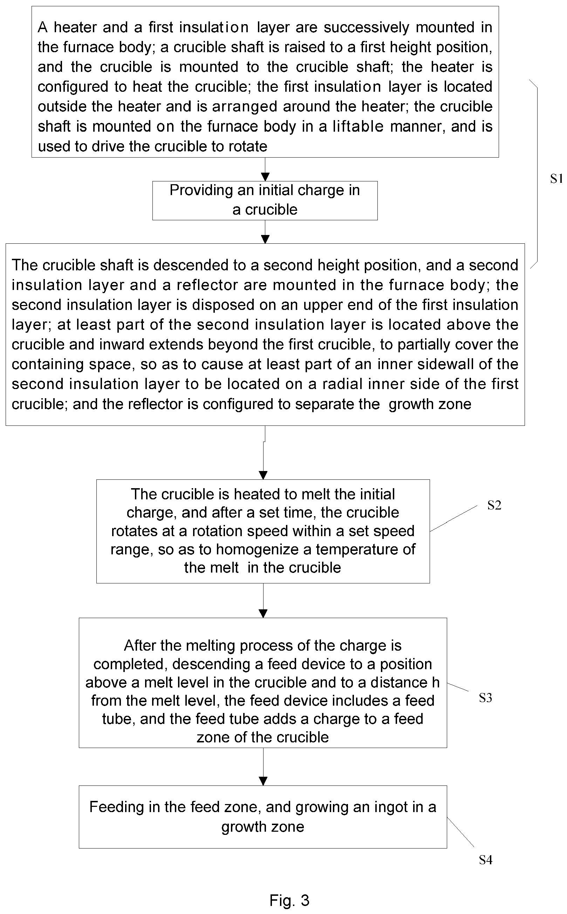

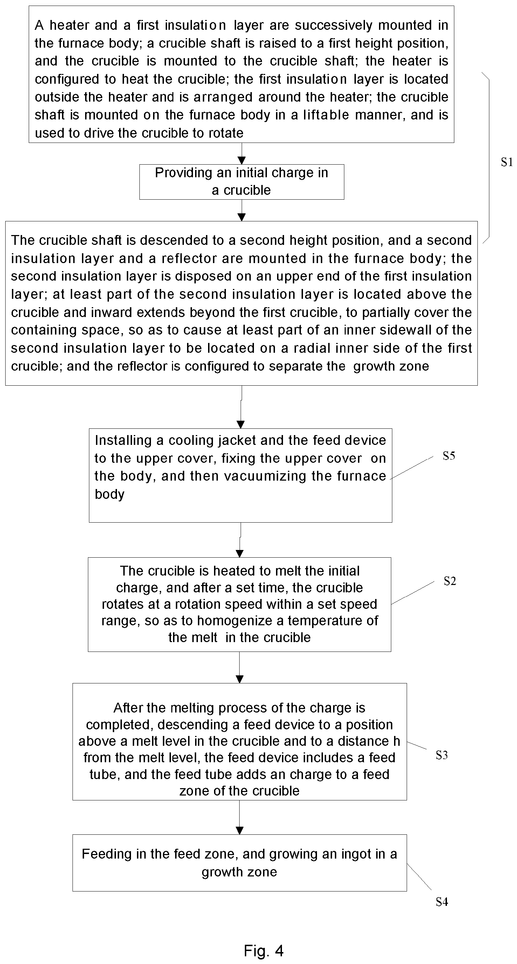

In some embodiments, as shown in Fig. 3 and Fig. 4, in step S1, before the initial charge is provided in the crucible 100, a heater 104 and a first insulation layer 1051 are successively mounted in the furnace body 200. A crucible shaft 106 is raised to a first height position, and the crucible 100 is mounted to the crucible shaft 106. Wherein, the heater 104 is used to heat the crucible 100. The first insulation layer 1051 is located outside the heater 104 and is disposed around the heater 104. For example, the first insulation layer 1051 is formed as a cylindric structure, so as to maintain the temperature in the furnace body 200, block heat radiation of the heater 104 and reduce heat energy loss, such that it is beneficial to increase the heat energy utilization rate of the crystal growing furnace, thereby guaranteeing the speed of charge melting. The crucible shaft 106 is mounted to the furnace body 200 in a liftable manner, and is configured to drive the crucible 100 to rotate. After the initial charge is provided in the crucible 100, the crucible shaft 106 is descended to a second height position, and a second insulation layer 1052 and a reflector 107 are mounted in the furnace body 200. The second insulation layer 1052 is disposed on an upper end of the first insulation layer 1051. At least part of the second insulation layer 1052 is located above the crucible 100 and inward extends beyond the first crucible 1, to partially cover the containing space 100a, so as to cause at least part of an inner sidewall of the second insulation layer 1052 to be located on a radial inner side of the first crucible 1. In this way, the second insulation layer 1052 may block the heat radiation of the melt in the containing space 100a, so as to further reduce the heat energy loss. The reflector 107 is used to separate the growth zone Ω3, such that the ingot in the growth zone Ω3 is prevented from being affected by radiant heat of the melt in the crucible 100 and the heater 104, thereby guaranteeing ingot solidification. In addition, the reflector 107 is able to separate the growth zone Ω3 from the feed zone Ω1, such that avoiding a problem that the ingot lose a single ingot structure due to a poor atmosphere of the growth zone Ω3 which caused by the melt in the feed zone Ω1 or feeding spattering.

It is apparent that, the first height position is located above the second height position. After the crucible shaft 106 is descended to the second height position, the reflector 107 is then mounted, such that the initial charge that has been added into the crucible 100 is prevented from coming into contact with a bottom of the reflector 107, so as to guarantee the successful mounting of the reflector 107, and in addition, the cleanness of the initial charge in the crucible 100 is also guaranteed.

Therefore, step S1 may include: successively mounting the heater 104 and the first insulation layer 1051 in the furnace body 200, raising the crucible shaft 106 to the first height position, and mounting the crucible 100 to the crucible shaft 106; then providing the initial charge in the crucible 100, then descending the crucible shaft 106 to the second height position, and mounting the second insulation layer 1052 and the reflector 107 in the furnace body 200. Therefore, by appropriately setting the sequence of mounting and loading components in the furnace body 200, the components in the furnace body 200 are conveniently and successfully mounted, and the initial charge that has been added into the crucible 100 is prevented from contacting with other components in the furnace body 200.

In an embodiment, the first height position is a highest position attained by the crucible shaft 106, and the second height position is a lowest position attained by the crucible shaft 106.

For example, in an example of Fig. 7, the crucible 100 includes a first crucible 1, a second crucible 2 and a third crucible 3. The heater 104 includes a side heater 1041. The side heater 1041 is disposed around the crucible 100, that is, the side heater 1041 is located on a radial outer side of the crucible 100. For example, the side heater 1041 may continuously extend in a circumferential direction of the crucible 100, so as to form a cylindric structure. The first insulation layer 1051 is formed as a cylindric structure and located on a radial outer side of the side heater 1041, so as to block the heat radiation of the heater 104, thereby reducing heat energy loss. The second insulation layer 1052 is disposed on an upper end of the first insulation layer 1051, and includes a first insulation sub-layer 1052a and a second insulation sub-layer 1052b that are axially disposed along the crucible 100. The second insulation sub-layer 1052b is disposed on the upper end of the first insulation layer 1051, and extends inward beyond the side heater 1041, so as to be disposed around the crucible 100. Then the second insulation sub-layer 1052b is located above the side heater 1041, and a radial inner end of the second insulation sub-layer 1052b is located on a radial inner side of the side heater 1041, such that a radial distance between the second insulation sub-layer 1052b and the crucible 100 is smaller, thereby it is beneficial to improve heat preservation and heat insulation effects of the first insulation layer 1051. The first insulation sub-layer 1052a is disposed on an upper end of the second insulation sub-layer 1052b, and is located above the crucible 100, so as to cover a part of the containing space 100a. The first insulation sub-layer 1052a extends inward at least to the radial inner side of the first crucible 1, such that the first insulation sub-layer 1052a may at least block the heat radiation of the melt in the first chamber R1, thereby further reducing the heat energy loss. It is apparent that, a part of the second insulation layer 1052 is located above the crucible 100, such that partial inner sidewall of the second insulation layer 1052 is located on the radial inner side of the first crucible 1.

For another example, in an example of Fig. 9, the crucible 100 includes a first crucible 1, a second crucible 2, a third crucible 3 and a fourth crucible 4. The fourth crucible 4 is disposed in the third chamber R3 to separate the third chamber R3 into a first sub-chamber R31 and a second sub-chamber R32. The heater 104 includes a side heater 1041. The side heater 1041 is disposed around the crucible 100, that is, the side heater 1041 is located on a radial outer side of the crucible 100. For example, the side heater 1041 may continuously extend in a circumferential direction of the crucible 100, so as to form a cylindric structure. The first insulation layer 1051 is formed as a cylindric structure and located on a radial outer side of the side heater 1041, so as to block the heat radiation of the heater 104, thereby reducing heat energy loss. The second insulation layer 1052 is disposed on an upper end of the first insulation layer 1051, and includes a first insulation sub-layer 1052a and a second insulation sub-layer 1052b that are disposed along an axial direction of the crucible 100. The second insulation sub-layer 1052b is disposed on the upper end of the first insulation layer 1051, and extends inward to not exceed the second crucible 2, such that the second insulation sub-layer 1052b may cover at least part of a top side of the first chamber R1, and the second insulation sub-layer 1052b does not cover a top side of the second chamber R2. That is to say, the second insulation sub-layer 1052b may cover a part of the top side of the first chamber R1, or the second insulation sub-layer 1052b may cover the entire top side of the first chamber R1. Therefore, the second insulation sub-layer 1052b may block the heat radiation of the melt in the first chamber R1, thereby further reducing the heat energy loss. The first insulation sub-layer 1052a is disposed on the upper end of the second insulation sub-layer 1052b, and at least extends inward to the third crucible 3, such that the first insulation sub-layer 1052a may at least cover a top side of the second chamber R2, and the first insulation sub-layer 1052a may or may not cover the third chamber R3. Therefore, the first insulation sub-layer 1052a may at least block the heat radiation of the melt in the second chamber R2. It is apparent that, the entire second insulation layer 1052 is located above the crucible 100, such that an entire inner side wall of the second insulation layer 1052 is located on the radial inner side of the first crucible 1.

In addition, in an example of Fig. 9, the distance between the first insulation sub-layer 1052a and the crucible 100 in the vertical direction is greater than the distance between the second insulation sub-layer 1052b and the crucible 100 in the vertical direction. Since the first insulation sub-layer 1052a is disposed corresponding to the second chamber R2, an avoidance space 1050 defined by the first insulation sub-layer 1052a and the second insulation sub-layer 1052b together is disposed above the second chamber R2. The avoidance space 1050 may cause silicon vapor guided here and the evaporated dopant to be completely driven by argon (or nitrogen), such that the atmosphere in the furnace body 200 is guaranteed, and the energy of the heater 104 reaching the position corresponding to the avoidance space 1050 has been decreased. The avoidance space 1050 is able to allow the heat energy at the position to move upward, such that a temperature gradient at the solid-melt interface is effectively increased, facilitating the crystal growing furnace to grow heavily-doped ingots with large sizes, so as to better meet the actual requirements.

In some embodiments, as shown in Fig. 7, the furnace body 200 includes a body 200a and an upper cover 200b. The heater 104, the insulation layer 105, the crucible shaft 106 and the reflector 107 are all mounted to the body 200a. The method of growing the ingot further includes: step S5, mounting a cooling jacket 108 and the feed device 101 to the upper cover 200b, fixing the upper cover 200b on the body 200a, and then vacuumizing the furnace body 200, so as to better meet pressure required for the growth of the ingots. Wherein, step S5 is between step S1 and step S2. The cooling jacket 108 is configured to cool the ingots, so as to guarantee the crystallization of the ingots.

Optionally, after the furnace body 200 is vacuumized, the pressure in the furnace body 200 is maintained between 20 torr and 50 torr, so as to better meet growth requirements of the ingots.

In some embodiments, the aperture of the first through hole 20 is d1, and the aperture of the second through hole 30 is d₂, where d₁ and d₂ meet: d₁ < d₂, such that the aperture of the first through hole 20 is relatively small. For example, the aperture of the first through hole 20 is less than or equal to the diameter of the particle in the first chamber R1, such that the problem that yield is affected due to the fact that the particles directly enter into the second chamber R2 without being melted and then enter the third chamber R3 is avoided, thereby it is beneficial to guarantee the yield of the ingots. The aperture of the second through hole 30 is greater than the aperture of the first through hole 20, such that the melt is prevented from gathering in the second chamber R2, causing retention of the melt, so as to guarantee the flow of the melt to be smoother. In addition, the charge and the dopant in the second chamber R2 are mostly melted, and the aperture of the second through hole 30 is relatively large, such that solid-melt interface vibration caused by the retention of the melt is prevented from affecting the follow-up ingot growing process.

Wherein, in some embodiments, both the first through hole 20 and the second through hole 30 are formed as circular holes. Definitely, when at least one of the first through hole 20 and the second through hole 30 is formed as a non-circular hole, the aperture of at least one of the first through hole 20 and the second through hole 30 may be understood as an equivalent diameter.

In some embodiments, as shown in Fig. 5, Fig. 6 and Fig. 8, the first through hole 20 is formed at the bottom of the second crucible 2, and is disposed adjacent to an R angle of the second crucible 2. For example, the first through hole 20 is disposed upward close to the R angle of the second crucible 2. After the particles are melted, since the crucible 100 is cold outside and hot inside, and the melt flows from outside to inside and flows downward under the action of gravity, the first through hole 20 is disposed adjacent to the R angle of the second crucible 2, such that the melt smoothly flows to the second chamber R2 by the first through hole 20. In addition, when the particles are incompletely melted, the particles become smaller and float upward under the action of buoyancy. If the first through hole 20 is disposed at an upper portion of the second crucible 2, the incompletely-melted particles may flow to the second chamber R2, easily causing a problem of affecting the growth of the ingot. Therefore, by disposing the first through hole 20 at the bottom of the second crucible 2, the problem that the yield is affected due to incompletely-melted particles entering the growth zone Ω3 is avoided.

Wherein, the R angle of the second crucible 2 may be understood as the corner of the second crucible 2. The position of the R angle of the crucible is well known to those skilled in the art and is not described herein again.

As shown in Fig. 6, there are multiple first through holes 20. The multiple first through holes 20 include a first feeding hole 20a and a second feeding hole 20b. The second feeding hole 20b is located above the first feeding hole 20a. The first feeding hole 20a may be a main feeding hole. By means of additionally disposing the second feeding hole 20b above the first feeding hole 20a, when the first feeding hole 20a is blocked, the melt in the first chamber R1 may still flow to the second chamber R2 by the second feeding hole 20b, so as to guarantee smooth flowing of the melt. Specifically, since the first chamber R1 is adapted to be constructed as a feeding zone, when feeding is performed in the first chamber R1, the particles have a certain falling speed, to cause the particles to flow to the bottom of the first chamber R1, so as to block the first feeding hole 20a. In this case, the first chamber R1 may still communicate with the second chamber R2 by the second feeding hole 20b, so as to guarantee the normal operation of the crucible 100.

Optionally, when feeding is performed in the first chamber R1, a feeding position may be located at a certain position of the first chamber R1, and the first feeding hole 20a may be located on a side of the second crucible 2 that is away from the feeding position.

It is to be noted that, the meaning of "multiple" is two or more. That "the second feeding hole 20b is located above the first feeding hole 20a" only indicates that the horizontal height of the second feeding hole 20b is higher than that of the first feeding holes 20a, which may mean that the second feeding hole 20b is located right above the first feeding hole 20a, or may mean that the second feeding hole 20b is located at an inclined upper portion of the first feeding hole 20a. In other words, in a circumferential direction of the second crucible 2, a relative position between the first feeding hole 20a and the second feeding hole 20b is specifically set according to a practical application, such that the central angle formed by the setting position of the first feeding hole 20a and the setting position of the second feeding hole 20b by using the center of the second crucible 2 as the center of a circle may range from 0° to 360° (including endpoint values).

For example, in an embodiment of Fig. 6, there are three first through holes 20, two first feeding holes 20a and one second feeding hole 20b; the second feeding hole 20b is located above the two first feeding holes 20a; and in the circumferential direction of the second crucible 2, the second feeding hole 20b is located between the two first feeding holes 20a.

In some embodiments, as shown in Fig. 5 and Fig. 8, the second through hole 30 is formed on a side of the third crucible 3 that is away from the first through hole 20. For the crucible 100, the first through hole 20 and the second through hole 30 are respectively located on two radial sides of the crucible 100, such that the melt flowing to the second chamber R2 by the first through hole 20 needs to flow around to the other side of the third crucible 3 to flow to the third chamber R3 by the second through hole 30. Therefore, the melt in the containing space 100a needs to flow a long path from the feeding position to the third chamber R3, such that the melt is prevented from rapidly flowing to easily cause the vibration of the melt level, thereby it is beneficial to guarantee the stability of the melt level.

For example, in embodiments of Fig. 5 and Fig. 8, both the first chamber R1 and the second chamber R2 are formed as annular structures. The second through hole 30 is formed on a radial side of the third crucible 3 that is away from the first through hole 20, such that the melt in the containing space 100a flows in a roundabout and zigzag way, so as to guarantee the stable melt level during the growth of the ingots or feeding.

In some embodiments, as shown in Fig. 5, the top end of the first crucible 1 is flush with the top end of the second crucible 2, such that the top end of the first crucible 1 and the top end of the second crucible 2 are approximately located on the same plane. In addition, the top end of the first crucible 1 and the top end of the second crucible 2 are located above the top end of the third crucible 3. That is to say, among the first crucible 1, the second crucible 2 and the third crucible 3, the height of the top end of the third crucible 3 is the lowest.

When the crucible 100 is applied to a monocrystal furnace, a cooling jacket 108 of the monocrystal furnace is disposed right above the growth zone Ω3; and on a plane perpendicular to a central axis of the crucible 100, an orthographic projection of the cooling jacket 108 is located within an orthographic projection range of the growth zone Ω3. By setting the height of the top end of the third crucible 3 to be relatively low relative to the height of the top end of the second crucible 2, the reflector 107 is disposed between the third crucible 3 and the cooling jacket 108, so as to separate the cooling jacket 108 from the third crucible 3, such that the growth of the ingots is prevented from being easily affected by the heat radiation generated by the high-temperature melt, thereby guaranteeing the solidification of the ingots. Definitely, the crucible 100 may be further applied to other devices.

In some embodiments, as shown in Fig. 5 and Fig. 8, the first crucible 1 includes a first body 11; the second crucible 2 includes a second body 21; and the third crucible 3 includes a third body 31. The first body 11, the second body 21 and the third body 31 are all formed as cylindric structures. The first body 11, the second body 21 and the third body 31 are successively disposed from outside to inside. The first body 11, the second body 21 and the third body 31 are coaxial, that is, a central axis of the first body 11, a central axis of the second body 21 and a central axis of the third body 31 are disposed in a coincided manner. In addition, the central axis of the first body 11 is formed as the central axis of the crucible 100. The first chamber R1 and the second chamber R2 may both be formed as the annular structures, such that when the crucible 100 is used, the crucible 100 is able to rotate around its central axis under the driving of the crucible shaft 106, then the first chamber R1 rotates around the central axis of the crucible 100. In this way, the feeding position of the first chamber R1 may rotate without following the crucible 100, facilitating the discharging arrangement of the crucible 100.

Wherein, the diameter D₁ of the first body 11, the diameter D₂ of the second body 21 and the diameter D₃ of the third body 31 meet an equation of Dₙ₊₁ = Dₙ*Xₙ, where n = 1 or 2, and 60%≤Xₙ≤80%. For example, Xₙ may be 60%, 70%, 80%, or the like.

Therefore, if D₂ = D₁*X₁, 60%≤X₁≤80%, it is ensured that the first chamber R1 has enough feeding space, such that the appropriate feeding amount of the charge is easy to implement, and it is ensured that the melt in the first chamber R1 has enough flow space, so as to make the melt in the first chamber R1 flow to the second chamber R2 by the first through hole 20. If D₃ = D₂*X₂, 60%≤X₂≤80%, on the premise that the third chamber R3 meets a space requirement for the growth of the ingots, it is beneficial to ensure that the second chamber R2 has enough space, such that the melt is more homogenized, and the melt in the second chamber R2 has enough flow space, so as to cause the melt in the second chamber R2 to flow to the third chamber R3 by the second through hole 30. X₁ and X₂ may or may not the same.

For example, in embodiments of Fig. 5 and Fig. 8, the first body 11 is located on the top of the first crucible 1, the second body 21 is located on the top of the second crucible 2, and the third body 31 is located on the top of the third crucible 3, where X₁ = X₂ = 80%, and D₂ = D₁*80%, D₃ = D₂*80%.

In some embodiments, as shown in Fig. 5 and Fig. 8, the first crucible 1 includes a crucible bottom wall 12 and a crucible sidewall 13. The crucible sidewall 13 extends upwards from an edge of the crucible bottom wall 12, and defines the containing space 100a together with the crucible bottom wall 12. Both the second crucible 2 and the third crucible 3 are formed as cylindric structures. The second crucible 2 is fitted with the crucible bottom wall 12 in a limited manner by a first mortise and tenon structure 5, and the third crucible 3 is fitted with the crucible bottom wall 12 in a limited manner by a second mortise and tenon structure 6. In this way, structures of the second crucible 2 and the third crucible 3 are simplified, and convenient processing is realized. In addition, convenient assembling between the second crucible 2 and the first crucible 1, and between the third crucible 3 and the first crucible 1 is achieved, such that the crucible 100 is formed as a stable whole structure, and damage and moving caused by high crucible rotation are avoided, thereby guaranteeing the reliable use of the crucible 100.

Specific structures of the first mortise and tenon structure 5 and the second mortise and tenon structure 6 may be designed according to the practical application, as long as the assembling between the second crucible 2 and the first crucible 1 is reliable, and the assembling between the third crucible 3 and the first crucible 1 is reliable.

It is to be noted that, in the description of the present invention, the "cylindric structure" should be understood in a broad sense and is not limited to a cylinder structure having a circular cross section. For example, the cylindric structure may be a polygonal cylinder structure, or a cylindrical structure with a constant cross-sectional area, for example, may be a conical cylinder structure.

In some embodiments, as shown in Fig. 8, the crucible 100 further includes a fourth crucible 4. The fourth crucible 4 is disposed in the third chamber R3 to separate the third chamber R3 into a first sub-chamber R31 and a second sub-chamber R32. A third through hole 40 is formed on the fourth crucible 4, so as to communicate the first sub-chamber R31 and the second sub-chamber R32. Therefore, the melt in the first sub-chamber R31 may flow to the second sub-chamber R32 by the third through hole 40, or the melt in the second sub-chamber R32 may flow to the first sub-chamber R31 by the third through hole 40. The second sub-chamber R32 communicates with the second chamber R2 by the first through hole 20, such that the uniformity of the melt in the first sub-chamber R31 is further improved, the stability of the melt level during feeding is guaranteed, and uniform distribution of radial resistance and axial resistance of the ingots are easy to be realized. Therefore, stable production is guaranteed, and the ingots grown by the crucible 100 have good quality.

For example, the top sides of the first sub-chamber R31 and the second sub-chamber R32 are disposed in an open manner. The first sub-chamber R31 is located inside the fourth crucible 4, and the second sub-chamber R32 is formed outside the fourth crucible 4. The first sub-chamber R31 is adapted to be constructed as the growth zone Ω3, and the second chamber R2 is adapted to be constructed as the dopant feed zone Ω2, such that the second chamber R2 is configured to feed the dopant.

In an example of Fig. 8, the feed device 101 includes the feed tube 1011 and the dopant feed tube 1012. The first chamber R1 is adapted to be constructed as the feed zone Ω1, the second chamber R2 is adapted to be constructed as the dopant feed zone Ω2, and the first sub-chamber R31 is adapted to be constructed as the growth zone Ω3. In step S3, the feed tube 1011 is disposed corresponding to the feed zone Ω1, so as to cause the feed tube 1011 to feed the first chamber R1. The dopant feed tube 1012 is disposed corresponding to the dopant feed zone Ω2, so as to cause the dopant feed tube 1012 to feed the second chamber R2.

During the use of the crucible 100, when the feed device 101 feeds , the charge (for example, silicon) is added to the first chamber R1, then the dopant (for example, arsenic) is added to the second chamber R2, and ingot growing is performed in the first sub-chamber R31. Since the melt in the first chamber R1 and the second chamber R2 needs to pass through the second sub-chamber R32 before flowing to the first sub-chamber R31, the second sub-chamber R32 may be adapted to be constructed as a "stirring zone", such that enough mixing space is provided for the melted charge and dopant, so that it is beneficial to further improve the uniformity of the melt in the first sub-chamber R31; and a good heat preservation effect is achieved, such that facilitating growth of ingots with higher quality. Furthermore, by disposing the second sub-chamber R32 to separate the first sub-chamber R31 from the first chamber R1 and the second chamber R2, a problem that easy disturbance of the melt level is avoided during feeding, such that the stability of the melt level during feeding is guaranteed, it is beneficial to achieve stable growth of the ingots, and uniform distribution of radial resistance and axial resistance of the ingots are realized, thereby guaranteeing stable production. In addition, the crucible 100 may rotate around its central axis during use. The stable melt level may prevent the solid-liquid interface during ingot pulling from protruding the ingot, such that during production by CCZ, the resistance of the ingot in an axial direction and a radial direction is further effectively controlled to be uniformly distributed, so as to further improve the quality of the ingot. For example, the resistance of a wafer used in an electronic product shall be within a narrow resistance range, and the ingot grown by the crucible 100 in the present invention may meet the above requirement without causing loss and waste of the charges and working hours, such that costs are saved.

It is to be noted that, the direction "outward" is defined as the direction away from the center axis of the crucible 100, and the opposite direction is defined as inward.

In step S1, the initial charge is separately loaded into the first chamber R1, the second chamber R2, the first sub-chamber R31 and the second sub-chamber R32. The particle diameter of the initial charge in the first chamber R1 is greater than the particle diameter of the initial charge in the first sub-chamber R31 and the particle diameter of the initial charge in the second sub-chamber R32, such that enough initial charge is contained in the first sub-chamber R31 and the second sub-chamber R32, avoid the problem of influencing the ingot growing due to the fact that the air bubbles are easily generated in the first sub-chamber R31 and the second sub-chamber R32 during material melting process.

Definitely, the present invention is not limited to the following. In some embodiments, as shown in Fig. 5, the crucible 100 includes the first crucible 1, the second crucible 2 and the third crucible 3, and does not include the fourth crucible 4. In this case, the first chamber R1 may further used to be constructed as the dopant feed zone Ω2, such that charge and impurities are added into the first chamber R1, and the second chamber R2 is constructed as the "melting zone" of the crucible 100.

In some embodiments, the aperture of the first through hole 20 is d₁, the aperture of the second through hole 30 is d₂, and the aperture of the third through hole 40 is d₃, where d₁, d₂ and d₃ meet: d₁ < d₂ < d₃, such that the aperture of the first through hole 20 is relatively small. For example, the aperture of the first through hole 20 may be less than or equal to the diameter of the particle in the first chamber R1, such that the particles may be prevented from directly entering the second chamber R2 without being melted and then entering the first sub-chamber R31 to affect the ingot growth and yield, thereby guaranteeing the yield of the ingots. The aperture of the second through hole 30 is greater than the aperture of the first through hole 20, such that the melt may be prevented from gathering in the second chamber R2, causing retention of the melt, so as to guarantee the flow of the melt to be smoother. In addition, the charge and the dopant in the second sub-chamber R32 are melted, and the aperture of the third through hole 40 is relatively large, such that solid-liquid interface vibration caused by the retention of the melt may be prevented from affecting the follow-up ingot growing process.

Wherein, the first through hole 20, the second through hole 30 and the third through hole 40 may be formed as circular holes. Definitely, when at least one of the first through hole 20, the second through hole 30 and the third through hole 40 is formed as a non-circular hole, the aperture of at least one of the first through hole 20, the second through hole 30 and the third through hole 40 is understood as an equivalent diameter.

In some embodiments, as shown in Fig. 8, the second through hole 30 is formed on the side of the third crucible 3 that is away from the first through hole 20; and the third through hole 40 is formed on a side of the fourth crucible 4 that is away from the second through hole 30. For the crucible 100, the first through hole 20 and the second through hole 30 are respectively located on two radial sides of the crucible 100, and the second through hole 30 and the third through hole 40 are respectively located on two radial sides of the crucible 100, such that the melt flowing to the second chamber R2 by the first through hole 20 needs to flow around to the other side of the third crucible 3 to flow to the second sub-chamber R32 by the second through hole 30, and the melt flowing to the second sub-chamber R32 by the second through hole 30 needs to flow around to the other side of the fourth crucible 4 to flow to the first sub-chamber R31 by the third through hole 40. Therefore, the melt in the containing space 100a needs to flow a long path from the feeding position to the first sub-chamber R31, such that a problem that the vibration of the melt level is easily caused by rapidly flowing of the melt is avoided, thereby it is beneficial to guarantee the stability of the melt level.

For example, in an example of Fig. 8, the first chamber R1, the second chamber R2, first sub-chamber R31 and the second sub-chamber R32 are all formed as annular structures. The second through hole 30 is formed on a radial side of the third crucible 3 that is away from the first through hole 20, and the third through hole 40 is formed on a radial side of the fourth crucible 4 that is away from the second through hole 30, such that the melt in the containing space 100a flows in a roundabout way, so as to guarantee the stable melt level during the growth of the ingots or feeding.

In some embodiments, as shown in Fig. 8, the top end of the first crucible 1, the top end of the second crucible 2 and the top end of the third crucible 3 are disposed flush with each other, such that the top end of the first crucible 1, the top end of the second crucible 2 and the top end of the third crucible 3 are approximately located on the same plane. In addition, the top end of the first crucible 1, the top end of the second crucible 2 and the top end of the third crucible 3 are located above the top end of the fourth crucible 4. That is to say, among the first crucible 1, the second crucible 2, the third crucible 3 and the fourth crucible 4, the height of the top end of the fourth crucible 4 is the lowest.

When the crucible 100 is applied to the monocrystal furnace, the cooling jacket 108 of the monocrystal furnace is disposed right above the growth zone Ω3; and on the plane perpendicular to the central axis of the crucible 100, the orthographic projection of the cooling jacket 108 is located within the orthographic projection range of the growth zone Ω3. By setting the height of the top end of the fourth crucible 4 to be relatively low relative to the height of the top end of the third crucible 3, the reflector 107 is disposed between the fourth crucible 4 and the cooling jacket 108, so as to separate the cooling jacket 108 from the fourth crucible 4, such that the growth of the ingots is prevented from being easily affected by the heat radiation generated by the high-temperature melt, thereby guaranteeing the solidification of the ingots. In addition, the heights of the top end of the second crucible 2 and the top end of the third crucible 3 are relatively high, the dopant (for example, a volatile dopant, such as arsenic) is prevented from being taken away by airflow. For example, the dopant is prevented from being taken away by an argon flow in the monocrystal furnace, such that the argon flow may be prevented from coming into contact with the solid-liquid interface to a certain extent. Therefore, the waste of the dopant is avoided, and nonuniform radial resistance of the ingots caused by nonuniform doping is avoided. Definitely, the crucible 100 may be further applied to other devices.

It is to be noted that, the top end of the first crucible 1, the top end of the second crucible 2 and the top end of the third crucible 3 are disposed flush with each other, which may include the following situations: 1. The top end of the first crucible 1, the top end of the second crucible 2 and the top end of the third crucible 3 are located on the same plane; and 2. The difference in height positions of the top end of the first crucible 1, the top end of the second crucible 2 and the top end of the third crucible 3 is small.

In some embodiments, as shown in Fig. 8, the first crucible 1 includes the first body 11; the second crucible 2 includes the second body 21; the third crucible 3 includes the third body 31; and the fourth crucible 4 includes a fourth body 41. The first body 11, the second body 21, the third body 31 and the fourth body 41 are all formed as cylindric structures. The first body 11, the second body 21, the third body 31 and the fourth body 41 are successively disposed from outside to inside. The first body 11, the second body 21, the third body 31 and the fourth body 41 are disposed coaxially, that is, the central axis of the first body 11, the central axis of the second body 21, the central axis of the third body 31 and a central axis of the fourth body 41 coincide with each other. In addition, the central axis of the first body 11 may be formed as the central axis of the crucible 100. The first chamber R1, the second chamber R2, first sub-chamber R31 and the second sub-chamber R32 are all formed as the annular structures, such that when the crucible 100 is used, the crucible 100 may rotate around its central axis, then the first chamber R1 and the second chamber R2 rotate around the central axis of the crucible 100. In this way, the feeding position of the first chamber R1 and the feeding position of the second chamber R2 may rotate without following the crucible 100, facilitating the feeding arrangement of the crucible 100.

The diameter D₁ of the first body 11, the diameter D₂ of the second body 21, the diameter D₃ of the third body 31 and the diameter D₄ of the fourth body 41 meet an equation of Dₙ₊₁ = Dₙ*Xₙ, where n = 1, 2, 3, 60%≤Xₙ≤80%. For example, Xₙ may be 60%, 70%, 80%, or the like.

Therefore, D₄ = D₃*X₃, 60%≤X₃≤80%, insofar as the first sub-chamber R31 is guaranteed to meet the space requirement for the growth of the ingots, it is ensured that the second sub-chamber R32 has enough space, such that the melt formed by the charge and the dopant is more homogenized, and it is beneficial to ensure that the melt in the second sub-chamber R32 has enough flow space, so as to cause the melt in the second sub-chamber R32 to flow to the first sub-chamber R31 by the third through hole 40. X₁, X₂ and X₃ may be equal or unequal. That is to say, X₁, X₂ and X₃ may meet: X₁ = X₂ = X₃, X₁≠X₂ = X₃, X₁ = X₂≠X₃ or X₁≠X₂≠X₃.

For example, in an example of Fig. 8, the first body 11 is located on the top of the first crucible 1, the second body 21 is located on the top of the second crucible 2, the third body 31 is located on the top of the third crucible 3, and the fourth body 41 is located on the top of the fourth crucible 4, where X₁ = X₂ = X₃ = 80%, and D₂ = D₁*80%, D₃ = D₂*80%, D₄ = D₃*80%.

In some embodiments, as shown in Fig. 8, the first crucible 1 includes the crucible bottom wall 12 and the crucible sidewall 13. The crucible sidewall 13 extends upwards from an edge of the crucible bottom wall 12, and defines the containing space 100a together with the crucible bottom wall 12. The second crucible 2, the third crucible 3 and the fourth crucible 4 are formed as the cylindric structures. The second crucible 2 is fitted with the crucible bottom wall 12 in a limited manner by a first mortise and tenon structure 5, the third crucible 3 is fitted with the crucible bottom wall 12 in a limited manner by a second mortise and tenon structure 6, and the fourth crucible 4 is fitted with the crucible bottom wall 12 in a limited manner by a third mortise and tenon structure 7. In this way, structures of the second crucible 2, the third crucible 3 and the fourth crucible 4 are easy to be simplified, and convenient processing is easy to be realized. In addition, convenient assembling between the second crucible 2 and the first crucible 1, between the third crucible 3 and the first crucible 1, and between the fourth crucible 4 and the first crucible 1 is beneficial to be achieved, such that the crucible 100 is formed as a stable whole, and damage and moving caused by high crucible rotation are avoided, thereby guaranteeing the reliable use of the crucible 100.

In some embodiments, as shown in Fig. 5 and Fig. 8, the crucible 100 further includes a tray 8. The tray 8 is supported at the bottom of the first crucible 1, such that a load-carrying capacity of the crucible 100 is improved. A top end of the tray 8 is located under the top end of the first crucible 1, the top end of the second crucible 2 and the top end of the third crucible 3. That is to say, in the first crucible 1, the second crucible 2, the third crucible 3 and the tray 8, a height position of the tray 8 is the lowest, such that insofar as the load-carrying capacity of the crucible 100 is guaranteed, a material using amount of the tray 8 is saved, and costs are reduced.

Optionally, in embodiments of Fig. 5 and Fig. 8, the tray 8 is a graphite member.

As shown in Fig. 5 and Fig. 8, the first crucible 1 includes the crucible bottom wall 12 and the crucible sidewall 13. The crucible sidewall 13 extends upwards from an edge of the crucible bottom wall 12, and defines the containing space 100a together with the crucible bottom wall 12. The top end of the tray 8 is adapted to be located above the melt level in the containing space 100a, and the height of a portion of the tray 8 which is beyond the crucible bottom wall 12 is half of the height of the crucible sidewall 13, such that the crucible 100 is able to stably carry the melt, and leakage due to too much melt in the containing space 100a is avoided.

Other structures and operations of the crucible 100 according to the embodiments of the present invention are known to those of ordinary skill in the art, and will not be described in detail here.

In the description of the present invention, it is to be noted that, terms such as "center", "transverse", "height", "up", "down", "top", "bottom", "inside", "outside", "axial", "radial", "circumferential" and the like are orientation or position relationships shown in the drawings, are adopted not to indicate or imply that indicated apparatuses or components must be in specific orientations or structured and operated in specific orientations but only to conveniently describe the present invention and simplify descriptions, and thus should not be construed as limits to the present invention.

In addition, the terms "first" and "second" are used for descriptive purposes only and are not to be construed as indicating or implying relative importance or implicitly specifying the number of technical features indicated. Furthermore, features delimited with "first", "second" may expressly or implicitly include one or more of those features. In the description of the invention, "a plurality of" means two or more, unless otherwise explicitly specified.

In the present invention, unless expressly specified and limited otherwise, the terms such as "mounting", "connected to each other", "connection" and "fixation" should be understood in a broad sense. For example, the term "connect" may be a fixed connection, a detachable connection, or an integrated connection. As an alternative, the term "connect" may be a mechanical connection, or an electrical connection. As an alternative, the term "connect" may be communication. As an alternative, the term "connect" may be a direct connection or an indirect connection by means of an intermediate medium; or may be an internal communication between two elements or an interaction relationship between two elements. For those of ordinary skill in the art, specific meanings of the above terms in the present invention may be understood according to a specific condition.

In the present invention, unless otherwise expressly specified and limited, a first feature being "on" or "under" a second feature may be direct contact between the first feature and second feature, or indirect contact between the first feature and second feature by means of an intermediate medium. In addition, the first feature being "over", "above" and "on" the second feature may be that the first feature is right above or at an inclined upper portion of the second feature, or simply indicate that the horizontal height of the first feature is higher than that of the second feature. The first feature being "beneath", "under" and "below" the second feature may be that the first feature is right under or at an inclined lower portion of the second feature, or simply indicate that the horizontal height of the first feature is less than that of the second feature.

In the description of the specification, descriptions of the terms "an embodiment," "some embodiments," "example," "specific example," or "some examples", mean that specific features, structures, materials, or characteristics described with reference to the implementations or examples are included in at least one implementation or example of the present invention. In this specification, schematic representations of the above terms do not necessarily refer to the same embodiment or example. In addition, the described particular features, structures, materials or characteristics may be combined in any suitable manner in any one or more embodiments or examples. In addition, a person skilled in the art may integrate and combine the different embodiments or examples described in this specification and the features of the different embodiments or examples without contradiction.

Although the embodiments of the present invention have been shown and described above, it may be understood by those skilled in the art that various changes, modifications, replacements and variations can be made in these embodiments without departing from the principle and objective of the present invention, and the scope of the present invention is defined by the claims and equivalents thereof.

## Claims

1. A method of growing the ingot, comprising following steps:
S1, providing an initial charge in a crucible (100);
S2, heating the crucible (100) to melt the initial charge, and after a set time, rotating the crucible (100) at a rotation speed within a set speed range, so as to homogenize a temperature of a melt in the crucible (100);
S3, after a melting process of the charge is completed, descending a feed device (101) to a position above a melt level in the crucible (100) and to a distance h from the melt level, the feed device (101) comprising a feed tube (1011), and the feed tube (1011) adding a charge to a feed zone (Ω1) of the crucible (100); and
S4, feeding in the feed zone (Ω1), and growing an ingot in a growth zone (Ω3), wherein
the crucible (100) comprises a first crucible (1), a second crucible (2) and a third crucible (3); a containing space (100a) is defined in the first crucible (1), and a top side of the containing space (100a) is disposed in an open manner; the second crucible (2) is disposed in the containing space (100a) and defines a first chamber (R1) together with the first crucible (1); the third crucible (3) is disposed in the second crucible (2) and defines a second chamber (R2) together with the second crucible (2); a third chamber (R3) is defined in the third crucible (3); a first through hole (20) is formed on the second crucible (2), so as to communicate the first chamber (R1) and the second chamber (R2); a second through hole (30) is formed on the third crucible (3), so as to communicate the second chamber (R2) and the third chamber (R3); the first chamber (R1) is adapted to be constructed as the feed zone (Ω1); the growth zone (Ω3) is located in the third chamber (R3);
in S1, the initial charge is separately loaded into the first chamber (R1), the second chamber (R2) and the third chamber (R3); and a particle diameter of the initial charge in the first chamber (R1) is greater than a particle diameter of the initial charge in the second chamber (R2) and in the third chamber (R3).

2. The method of growing the ingot according to claim 1, wherein a rotation speed ranges from 0.2 r/m to 3 r/m within the set rotation speed range.

3. The method of growing the ingot according to claim 1, wherein the distance h meets: 2 mm ≤ h ≤ 4 mm.

4. The method of growing the ingot according to claim 1, wherein S4 comprises:
S41, seed: immersing a part of a seed (102) below the melt level in the crucible (100), and starting a magnetic field apparatus (103);
S42, neck: pulling the seed (102) at a speed within a set moving speed range for neck, so as to eliminate dislocation;
S43, crown and shoulder: controlling a heating power and a pulling speed of the seed (102), so as to increase a diameter of the ingot to a set diameter; and
S44, body and feeding: producing equal-diameter growing of the ingot in the growth zone (Ω3), in the feed zone (Ω1), adding the charge to the feed zone (Ω1) of the crucible (100) by the feed tube (1011), and controlling a feeding amount of the feed device to be equal to a yield of the ingot, so as to maintain the constant melt level, wherein
the crucible (100) is installed in a furnace body (200) of a crystal growing furnace, and the magnetic field apparatus (103) is installed outside the furnace body (200) and generates a magnetic fields.

5. The method of growing the ingot according to claim 1, wherein in S1,
before the initial charge is provided in the crucible (100), a heater (104) and a first insulation layer (1051) are successively mounted in the furnace body (200); a crucible shaft (106) is raised to a first height position, and the crucible (100) is mounted to the crucible shaft (106); the heater (104) is configured to heat the crucible (100); the first insulation layer (1051) is located outside the heater (104) and is arranged around the heater (104); the crucible shaft (106) is mounted on the furnace body (200) in a liftable manner, and is used to drive the crucible (100) to rotate;
after the initial charge is provided in the crucible (100), the crucible shaft (106) is descended to a second height position, and a second insulation layer (1052) and a reflector (107) are mounted in the furnace body (200); the second insulation layer (1052) is disposed on an upper end of the first insulation layer (1051); at least part of the second insulation layer (1052) is located above the crucible (100) and inward extends beyond the first crucible (1), to partially cover the containing space (100a), so as to cause at least part of an inner sidewall of the second insulation layer (1052) to be located on a radial inner side of the first crucible (1); and the reflector (107) is configured to separate the growth zone (Ω3).

6. The method of growing the ingot according to claim 5, wherein the furnace body (200) comprises a body (200a) and an upper cover (200b); the heater (104), the insulation layer (105), the crucible shaft (106) and the reflector (107) are all mounted on the body (200a); and the method of growing the ingot further comprises:
S5, installing a cooling jacket (108) and the feed device (101) to the upper cover (200b), fixing the upper cover (200b) on the body (200a), and then vacuumizing the furnace body (200), wherein the cooling jacket (108) is configured to cool the ingot, wherein S5 is between S1 and S2.

7. The method of growing the ingot according to claim 1, wherein an aperture of the first through hole (20) is d₁, and an aperture of the second through hole (30) is d₂, wherein d₁ and d₂ meet: d₁ < d₂.

8. The method of growing the ingot according to claim 1, wherein the first through hole (20) is formed at a bottom of the second crucible (2) and is adjacent to an R angle of the second crucible (2);
there are multiple first through holes (20), and the multiple first through holes (20) comprise a first feeding hole (20a) and a second feeding hole (20b); and the second feeding hole (20b) is located above the first feeding hole (20a).

9. The method of growing the ingot according to claim 1, wherein the first crucible (1) comprises a crucible bottom wall (12) and a crucible sidewall (13), wherein the crucible sidewall (13) extends upwards from an edge of the crucible bottom wall (12) and defines the containing space (100a) together with the crucible bottom wall (12), both the second crucible (2) and the third crucible (3) are formed as cylindric structures, the second crucible (2) is fitted with the crucible bottom wall (12) in a limited manner by a first mortise and tenon structure (5), and the third crucible (3) is fitted with the crucible bottom wall (12) in a limited manner by a second mortise and tenon structure (6).

10. The method of growing the ingot according to claim 1, wherein a top end of the first crucible (1) and a top end of the second crucible (2) are flush with each other and are both located above a top end of the third crucible (3).

11. The method of growing the ingot according to any one of claims 1 to 10, wherein the crucible further comprises:
a fourth crucible (4), disposed in the third chamber (R3) so as to separate the third chamber (R3) into a first sub-chamber (R31) and a second sub-chamber (R32), wherein a third through hole (40) is formed on the fourth crucible (4), so as to communicate the first sub-chamber (R31) and the second sub-chamber (R32); the second sub-chamber (R32) communicates with the second chamber (R2) by the second through hole (30); the first sub-chamber (R31) is adapted to be constructed as the growth zone (Ω3), and the second chamber (R2) is adapted to be constructed as a dopant feed zone (Ω2);
wherein, in S1, the particle diameter of the initial charge in the first chamber (R1) is greater than a particle diameter of the initial charge in the first sub-chamber (R31) and a particle diameter of the initial charge in the second sub-chamber (R32); the feed device (101) further comprises a dopant feed tube (1012); and in S3, the feed tube (1011) is corresponding to the feed zone (Ω1), so as to make the feed tube (1011) add the charge to the first sub-chamber (R31), and the dopant feed tube (1012) is corresponding to the dopant feed zone (Ω2), so as to make the dopant feed tube (1012) add dopants to the second sub-chamber (R32).

12. The method of growing the ingot according to claim 11, wherein an aperture of the first through hole (20) is d₁, an aperture of the second through hole (30) is d₂, and a diameter of the third through hole (40) is d₃, wherein d₁, d₂ and d₃ meet: d₁<d₂<d₃.

13. The method of growing the ingot according to claim 11, wherein a top end of the first crucible (1), a top end of the second crucible (2) and a top end of the third crucible (3) are flush with each other and are all located above a top end of the fourth crucible (4).

14. The method of growing the ingot according to claim 1, wherein the crucible (100) further comprises:
a tray (8), supported at a bottom of the first crucible (1), wherein a top end of the tray (8) is located under a top end of the first crucible (1), a top end of the second crucible (2) and a top end of the third crucible (3); the first crucible (1) comprises a crucible bottom wall (12) and a crucible sidewall (13), and the crucible sidewall (13) extends upwards from the crucible bottom wall (12) and defines the containing space (100a) together with the crucible bottom wall (12); and
the top end of the tray (8) is adapted to be located above the melt level in the containing space (100a), and a height of a portion of the tray (8) which is beyond the crucible bottom wall (12) is half of a height of the first crucible (1).
